(19) Europäisches Patentamt
European Patent Office
Office européen des brevets

(11) **EP 1 921 755 A2**

(12) **EUROPEAN PATENT APPLICATION**

(43) Date of publication:
**14.05.2008 Bulletin 2008/20**

(51) Int Cl.:
*H04B 1/18* (2006.01)   *H03J 5/00* (2006.01)

(21) Application number: **07120376.4**

(22) Date of filing: **09.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **10.11.2006 JP 2006304739**
**19.02.2007 JP 2007037555**
**13.03.2007 JP 2007063196**

(71) Applicant: **MATSUSHITA ELECTRIC INDUSTRIAL CO., LTD**
**Kadoma-shi, Osaka 571-8501 (JP)**

(72) Inventors:
• **Noda, Masaaki**
  **c/o Matsushita Electric Industrial Co., Ltd.**
  **Osaka Osaka 540-6207 (JP)**
• **Namba, Akihiko**
  **c/o Matsushita Electric Industrial Co., Ltd.**
  **Osaka Osaka 540-6207 (JP)**
• **Iwasa, Masaharu**
  **c/o Matsushita Electric Industrial Co., Ltd.**
  **Osaka Osaka 540-6207 (JP)**

(74) Representative: **Zimmer, Franz-Josef**
**Grünecker, Kinkeldey,**
**Stockmair & Schwanhäusser**
**Anwaltssozietät**
**Maximilianstrasse 58**
**80538 München (DE)**

(54) **Electronic tuner and portable telephone device using the same**

(57)    A high-frequency amplifier inserted between a television input terminal and a first filter and having a current control input for controlling a current value is provided, together with a current control unit for controlling the current of the high-frequency amplifier, and the current of the high-frequency amplifier is set larger while the portable telephone is sending a transmission signal.

FIG. 1

EP 1 921 755 A2

## Description

### Technical Field

The invention relates to an electronic tuner capable of receiving television broadcast signals while a portable telephone is being used, and a portable telephone device using the same.

### Background Art

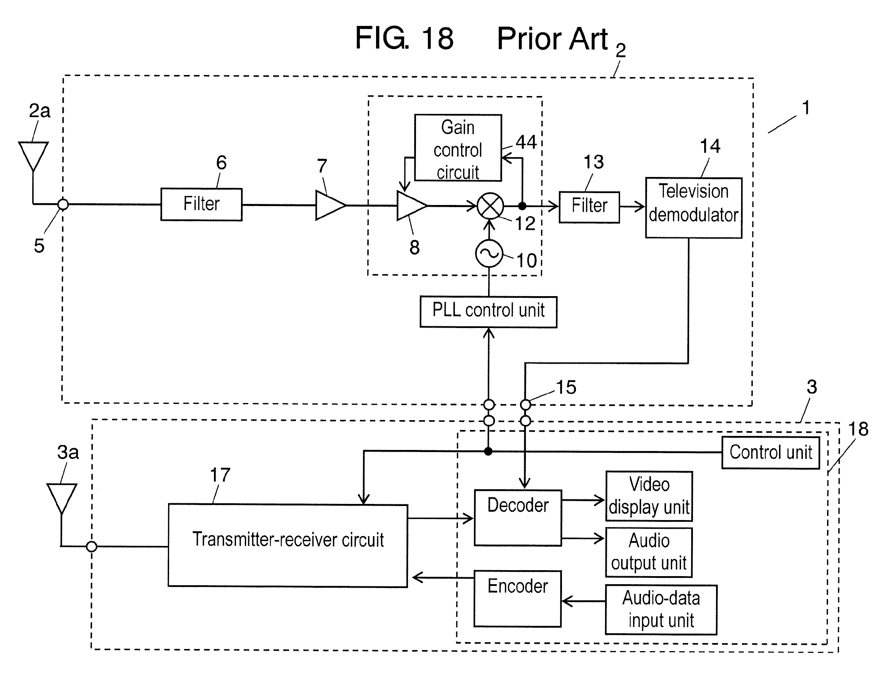

A conventional portable telephone device 1 is explained below by referring to FIG.18.

FIG. 18 is a block diagram of a conventional portable telephone device. In FIG. 18, a conventional portable telephone device 1 is composed of an electronic tuner 2 for receiving television broadcast signals, and a portable telephone 3. The electronic tuner 2 includes a television input terminal 5 for receiving television broadcast signals, a filter 6 connected to this television input terminal 5 for suppressing other signals than the television broadcast signals, a high-frequency amplifier 7 to which the output of this filter 6 is connected, a high-frequency amplifier 8 to which the output of this high-frequency amplifier 7 is connected and capable of controlling the gain, a mixer 12 receiving the output of this high-frequency amplifier 8 at one input and receiving the output of an oscillator 10 at other input, a filter 13 to which the output of this mixer 12 is connected, a television demodulator 14 to which the output of this filter 13 is connected, and an output terminal 15 to which the output of this television demodulator 14 is connected.

On the other hand, the portable telephone 3 includes a transmitter-receiver circuit 17, and a signal processing circuit 18 for receiving signals from this transmitter-receiver circuit 17 and the output circuit 15.

In such conventional electronic tuner 2, distortion occurs in the electronic tuner 2 due to transmission signal from the portable telephone 3 in use, and television broadcast signal cannot be received at high quality. To suppress the transmission signal from the portable telephone 3, the filter 6 of multi-stage structure is connected to the television input terminal 5 of the electronic tuner 2.

However, for example, the channel of highest frequency of UHF broadcast signal is 770 MHz, and the transmission signal from the portable telephone 3 is 830 MHz, and they are very close. The UHF broadcast signal is particularly small in the suburbs, and as compared with the UHF broadcast signal, the transmission signal from the portable telephone 3 is very large.

Moreover, a portable telephone antenna 3a provided in the portable telephone 3 and a television antenna 2a are very close to each other in distance. Accordingly, the attenuation amount to transmission signal in the filter 6 of the electronic tuner 2 is required to be very large, about more than 70 dB.

In the conventional electronic tuner 2, hence, it is needed to insert such filter 6 between the television input terminal 5 and high-frequency amplifier 7. Such filter 6 having a large attenuation amount of about 70 dB is formed in multiple stages. As a result, the insertion loss is very large, about 3 to 4 dB.

Since such filter 6 of large insertion loss is directly connected to the output of the television input terminal 5, when the television broadcast is small, the reception sensitivity deteriorates by the portion of insertion loss of 3 to 4 dB of the filter 6.

### Summary of the Invention

The invention is intended to present an electronic tuner of excellent reception sensitivity by reducing interference due to transmission signal from the portable telephone in use.

The electronic tuner of the invention includes a first high-frequency amplifier inserted between a television input terminal and a first filter and having a current control input for controlling a current value, and a current control unit inserted between the output of this first high-frequency amplifier and the current control input, for controlling the current of the first high-frequency amplifier by detecting a transmission signal, and while the portable telephone is transmitting the transmission signal, the current of the first high-frequency amplifier is set larger.

The electronic tuner of the invention, in other aspect, includes a first high-frequency amplifier inserted between a television input terminal and a first filter and having a current control input for controlling a current value, a transmission signal input terminal for receiving part of a transmission signal, and a current control unit for detecting a part of the transmission signal from this transmission signal input terminal and supplying a current control signal to the current control unit, and while the portable telephone is transmitting the transmission signal, the current of the first high-frequency amplifier is set larger.

Thus, by the current control unit for detecting the transmission signal from the portable telephone in use, the current value of the first high-frequency amplifier can be set larger, and interference by portable telephone can be suppressed.

Besides, since the first high-frequency amplifier is inserted between the television input terminal and the first filter, deterioration of reception sensitivity can be improved.

While the portable telephone is not in use, the current of the first high-frequency amplifier can be set smaller, and hence power consumption can be saved.

**Brief Description of the Drawings**

FIG. 1 is a block diagram of portable telephone device in preferred embodiment 1 of the invention.

FIG. 2 is a diagram showing relation between television broadcast signal and transmission signal of portable telephone in portable telephone device in preferred embodiment 1 of the invention.

FIG. 3A is a characteristic diagram of degree of amplification to current in portable telephone device in preferred embodiment 1 of the invention.

FIG. 3B is a characteristic diagram of Noise Figure to current in portable telephone device in preferred embodiment 1 of the invention.

FIG. 3C is a characteristic diagram of $V_{(P1dB)}$ to current in portable telephone device in preferred embodiment 1 of the invention.

FIG. 4 is a characteristic diagram of bit error rate of electronic tuner to input signal level in portable telephone device in preferred embodiment 1 of the invention.

FIG. 5 is a circuit diagram of first filter in portable telephone device in preferred embodiment 1 of the invention.

FIG. 6 is a selection characteristic diagram of first filter in portable telephone device in preferred embodiment 1 of the invention.

FIG. 7A is a time chart of transmission signal in portable telephone device in preferred embodiment 1 of the invention.

FIG. 7B is a time chart of current control signal in portable telephone device in preferred embodiment 1 of the invention.

FIG. 8 is a block diagram of portable telephone device in preferred embodiment 2 of the invention.

FIG. 9 is a circuit diagram of extraction circuit using directional coupler in portable telephone device in preferred embodiment 2 of the invention.

FIG. 10 is a circuit diagram of extraction circuit using power distributor in portable telephone device in preferred embodiment 2 of the invention.

FIG. 11 is a block diagram of portable telephone device in preferred embodiment 3 of the invention.

FIG. 12 is a block diagram of transmitter-receiver circuit in portable telephone device in preferred embodiment 3 of the invention.

FIG. 13 is a circuit diagram of detection circuit in portable telephone device in preferred embodiment 3 of the invention.

FIG. 14A is a time chart of transmission signal in portable telephone device in preferred embodiment 3 of the invention.

FIG. 14B is a time chart of current control signal in portable telephone device in preferred embodiment 3 of the invention.

FIG. 15 is a block diagram of portable telephone device in preferred embodiment 4 of the invention.

FIG. 16 is a block diagram of transmitter-receiver circuit in portable telephone device in preferred embodiment 4 of the invention.

FIG. 17 is a block diagram of portable telephone device in preferred embodiment 5 of the invention.

FIG. 18 is a block diagram of portable telephone device in prior art.

**Detailed Description of the Preferred Embodiments**

(Preferred Embodiment 1)

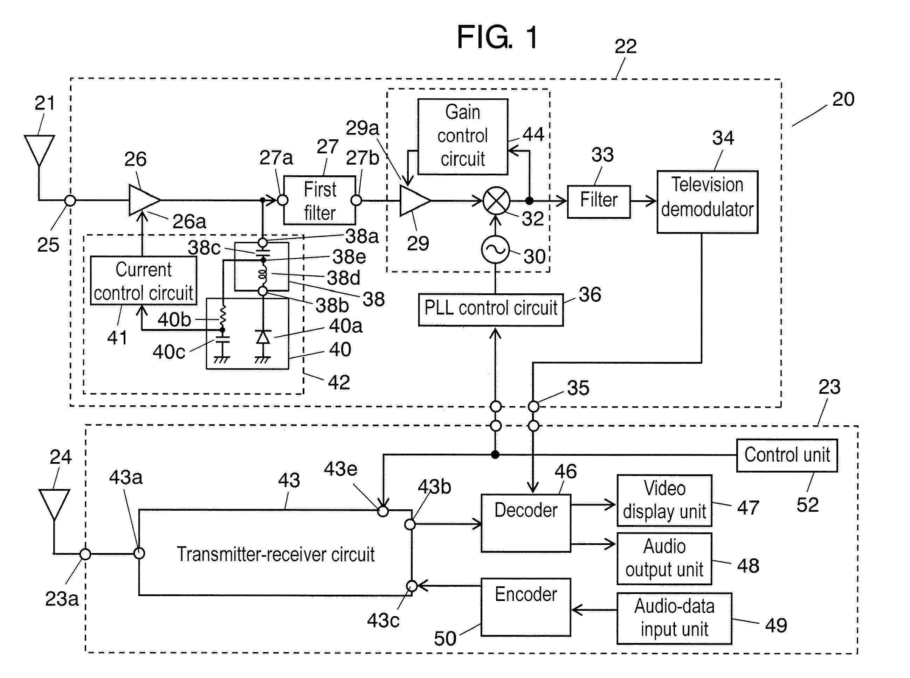

FIG. 1 is a block diagram of portable telephone device in preferred embodiment 1 of the invention. In FIG. 1, a portable telephone device 20 is composed of an electronic tuner 22 for receiving television broadcast signals (VHF broadcast signal, UHF broadcast signal) from a television antenna 21, and a portable telephone 23 connected to a portable telephone antenna 24.

The electronic tuner 22 is explained in the first place. This electronic tuner 22 includes a television input terminal 25 connected to the television antenna 21, a high-frequency amplifier 26 connected to the television input terminal 25 and having a current control input 26a for controlling a current value, a first filter 27 to which the output of this high-frequency amplifier 26 is connected for suppressing other signals than television broadcast signals, a high-frequency amplifier 29 to which the output of this first filter 27 is connected and having a gain control input 29a for controlling the gain, a mixer 32 for receiving the output of this high-frequency amplifier 29 at one input and receiving the output of an oscillator 30 at other input, a filter 33 to which the output of this mixer 32 is connected for passing an intermediate frequency signal, a television demodulator 34 to which the output of this filter 33 is connected, a television output terminal 35 for receiving a TS (transport stream) signal from this television demodulator 34, a PLL control circuit 36 for controlling the PLL of the oscillator 30, an input-output terminal 23a for receiving a transmission signal from the portable telephone 23, a third filter 38 connected to the output of the high-frequency amplifier 26 for passing the transmission signal from the portable telephone 23, a detection circuit 40 to which the output of this third filter 38 is connected for detecting the transmission signal, and a current control circuit 41 connected between the output of this detection circuit 40 and the current control input 26a, for controlling the current value of the high-frequency amplifier 26.

A current control unit 42 is composed of the third filter 38, detection circuit 40, and current control circuit 41. The output of the mixer 32 is connected to the input of a gain control circuit 44. The output of this gain control circuit 44 is connected to the gain control input 29a.

In the third filter 38, a capacitor 38c and an inductor 38d are connected sequentially from an input terminal 38a to an output terminal 38b.

The detection circuit 40 includes a wave detector 40a connected between the output terminal 38b of the third filter 38 and the ground, a resistance 40b connected between a junction 38e of the capacitor 38c and the inductor 38d and the input of the current control circuit 41, and a capacitor 40c connected between the input of the current control circuit 41 and the ground.

In the electronic tuner 22 having such configuration, the operation is described below. A television broadcast signal received in the antenna 21 is fed into the high-frequency amplifier 26. The output signal from the high-frequency amplifier 26 is fed into the first filter 27 for suppressing the transmission signal from the portable telephone.

The output signal from the first filter 27 is controlled in gain by the high-frequency amplifier 29, and is supplied into one input of the mixer 32, and an output signal from the oscillator 30 is supplied in other input.

An intermediate signal of, for example, 57 MHz issued from the mixer 32 is supplied in the filter 33, and interference signals other than desired signals are suppressed. The oscillator 30 is controlled in the frequency by a control signal from the PLL control circuit 36.

A gain control voltage from the gain control circuit 44 is supplied in the gain control input 29a of the high-frequency amplifier 29. As a result, the gain is controlled so that the output signal from the mixer 32 may be at a constant level.

As the input to the gain control circuit 44, meanwhile, the output of the filter 33 may be also supplied. In this case, interference signals such as transmission signal and adjacent channels can be suppressed by the filter 33, effects of interference signals on the gain control can be reduced.

The output signal of the mixer 32 is supplied into the television demodulator 34 after the interference signals are sufficiently suppressed by the filter 33. The TS signal from the television demodulator 34 is issued from the television output terminal 35.

In this manner, the television broadcast signal entered in the television input terminal 25 is amplified in the high-frequency amplifier 26, and the gain is controlled by the high-frequency amplifier 29, the frequency is converted by the mixer 32, and after the transmission signal or interference signal is suppressed by the first filter 27 and filter 33, a desired signal is put into the television demodulator 34. The TS signal demodulated in the television demodulator 34 is issued from the television output terminal 35.

Next, the portable telephone 23 is explained. The portable telephone 23 includes an input-output terminal 23a to which a portable telephone antenna 24 is connected, a transmitter-receiver circuit 43 connected to this input-output terminal 23a, a decoder 46 for decoding an input signal to which an output terminal 43b of the transmitter-receiver circuit 43 and the output of the television demodulator 34 are connected, a video display unit 47 and an audio output unit 48 to which the output of this decoder 46 is connected, an audio-data input unit 49 for receiving audio and data signal, an encoder 50 connected between this audio-data input unit 49 and an input terminal 43c of the transmitter-receiver circuit 43, for encoding the audio and data signal, and a control unit 52 for controlling the transmitter-receiver circuit 43 and PLL control circuit 36.

In the portable telephone 23 having such configuration, the operation is described below. By a control signal from the control unit 52, the portable telephone 23 is put in service. As a result, the transmission signal from the transmitter-receiver circuit 43 of the portable telephone 23 is issued from the portable telephone antenna 24.

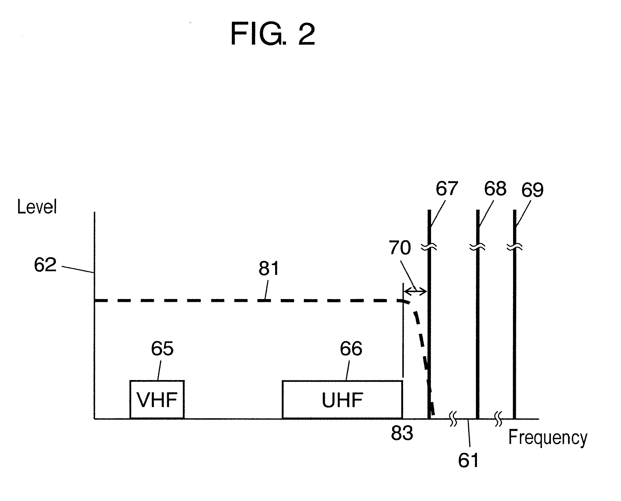

FIG. 2 is a diagram showing the relation of television broadcast signal and transmission signal of portable telephone in the portable telephone device in preferred embodiment 1 of the invention. An axis of abscissas 61 denotes the frequency (MHz), and an axis of ordinates 62 represents the level (dBm). In FIG. 2, a VHF broadcast signal 65 has a frequency band of 90 MHz to 220 MHz. A UHF broadcast signal 66 has a frequency band of 470 MHz to 770 MHz.

Transmission signals 67, 68, 69 from the transmitter-receiver circuit 43 of the portable telephone 23 may reach a level of +28 dBm at the input-output terminal 23a, for example, in the PDC system in Japan. Transmission signal Vtx issued from the input-output terminal 23a is transmitted from the portable telephone antenna 24 and propagates in the air, and is received in the television reception antenna 21 provided near the portable telephone antenna 24.

The transmission signals 68, 69 are examples of signals issued from the transmitter circuit of the portable telephone utilizing different frequency bands, and are respectively 1.5 GHz and 1.9 GHz in frequency. These signals are sufficiently remote from the frequency of UHF broadcast signal 66, and effects are small.

However, the television antenna 21 and portable telephone antenna 24 are contained in a small size of portable telephone device 20, and a sufficient distance cannot be provided between the television antenna 21 and portable telephone antenna 24 in terms of high frequency.

Accordingly, the transmission signal issued from the portable telephone antenna 24 is borne in air and received by the television antenna 21. Suppose the isolation Viso from the portable telephone antenna 24 to the television antenna 21 to be, for example, 30 dB.

Transmission signal Vu received in the television antenna 21 is -2 dBm according to formula (1).

$$Vu = Vtx - Viso$$
$$= +28dBm - 30dB$$
$$= -2dBm \hspace{3cm} (1)$$

where Vtx is transmission signal level issued from the input terminal 42, and Viso is the isolation from the portable telephone antenna 24 to the television antenna 21.

This transmission signal Vu is suppressed by the first filter 27 and filter 33, and is put into the television demodulator 34. In the first filter 27, however, the transmission signal is not suppressed sufficiently. Such transmission signal is amplified by the high-frequency amplifiers 26, 29, and is put into the mixer 32. Hence, in the mixer 32, distortion by transmission signal is most likely to occur, and the interference performance of the electronic tuner 22 is determined mostly by the transmission signal Vu.

To suppress interference in the mixer 32, it is important to suppress the transmission signal by the first filter 27. The required suppression ratio S1 of transmission signal by the first filter 27 is explained below.

Suppose the input level $V_{(P1dB)}$ of the mixer 32 to be -40 dm. Herein, $V_{(P1dB)}$ is an input signal level at which the output signal level is 1 dB due to increase of input signal level and the output signal level is saturated.

The required suppression ratio S1 in the first filter 27 inserted in a front stage of the mixer 32 is 68 dB, about 70 dB, according to formula (2). In this case, power gain G1 of the high-frequency amplifier 26 is supposed to be +15 dB, and power gain G2 of the high-frequency amplifier 29 is supposed to be +15 dB.

$$S1 = Vu + G1 + G2 - V_{(P1dB)}$$
$$= -2dBm + 15dB + 15dB - (-40dBm)$$
$$= 68dB \hspace{3cm} (2)$$

where G1 is power gain (dB) of the high-frequency amplifier 26, and G2 is power gain (dB) of the high-frequency amplifier 29, and $V_{(P1dB)}$ is input level (dBm) of the mixer 32.

However, interval 70 of highest frequency channel (62ch) of transmission signal 67 and UHF broadcast signal 66 is 60 MHz and is very close.

The electronic tuner 22 capable of improving both performances of interference characteristic by transmission signal and reception sensitivity by filter loss is explained below.

First, a method for improving the reception sensitivity is explained by referring to FIG. 1. In the portable telephone device in preferred embodiment 1 of the invention, the high-frequency amplifier 26 of medium power type having excellent Noise Figure and distortion characteristic is inserted between the television input terminal 25 and the first filter 27.

By inserting the high-frequency amplifier 26 before the first filter 27, the insertion loss by the first filter 27 can be lessened. That is, the reception sensitivity can be improved.

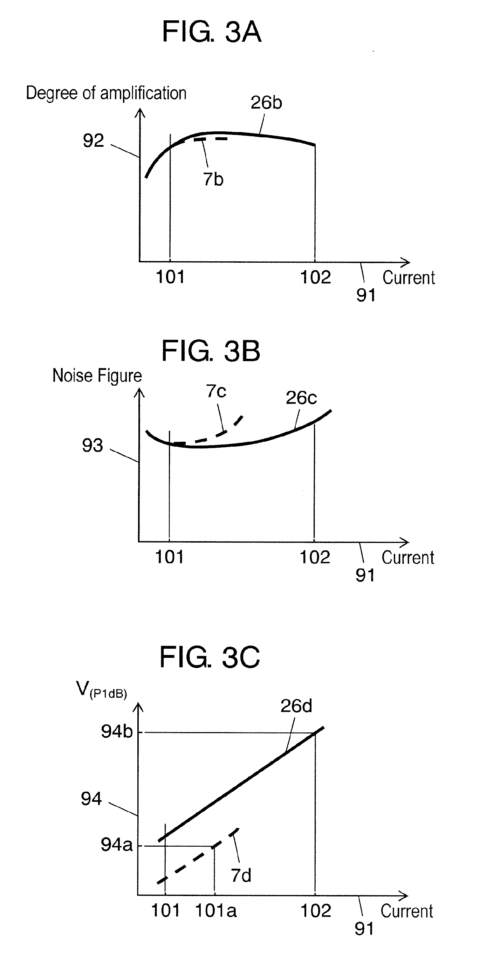

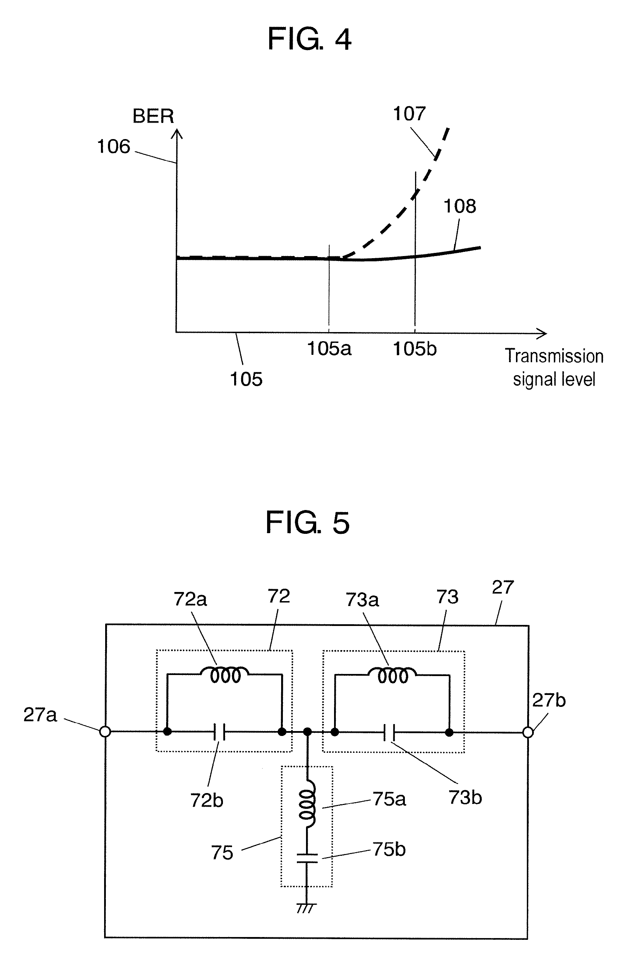

Referring to FIG. 3A to FIG. 3C and FIG. 4, a method for improving the interference by transmission signal of the high-frequency amplifier 26 is explained.

In the high-frequency amplifier 26 inserted at the television antenna 21 side from the first filter 27, interference occurs due to transmission signal of the portable telephone 23 in use. To improve this interference, the high-frequency amplifier 26 is a semiconductor element of medium power type having excellent distortion characteristic as shown in FIG. 3A to FIG. 3C.

FIG. 3A is a characteristic diagram of degree of amplification to current in the portable telephone device in preferred embodiment 1 of the invention. In FIG. 3A, reference numeral 92 is a degree of amplification to current 91, and a degree of amplification 7b of conventional high-frequency amplifier 7 (see FIG. 18), and a degree of amplification 26b of the high-frequency amplifier 26 of the invention are indicated by dotted line and solid line, respectively.

FIG. 3B is a characteristic diagram of Noise Figure to current in the portable telephone device in preferred embodiment 1 of the invention. In FIG. 3B, reference numeral 93 is a Noise Figure to current 91, and a Noise Figure 7c of conventional high-frequency amplifier 7, and a Noise Figure 26c of the high-frequency amplifier 26 of the invention are indicated by dotted line and solid line, respectively.

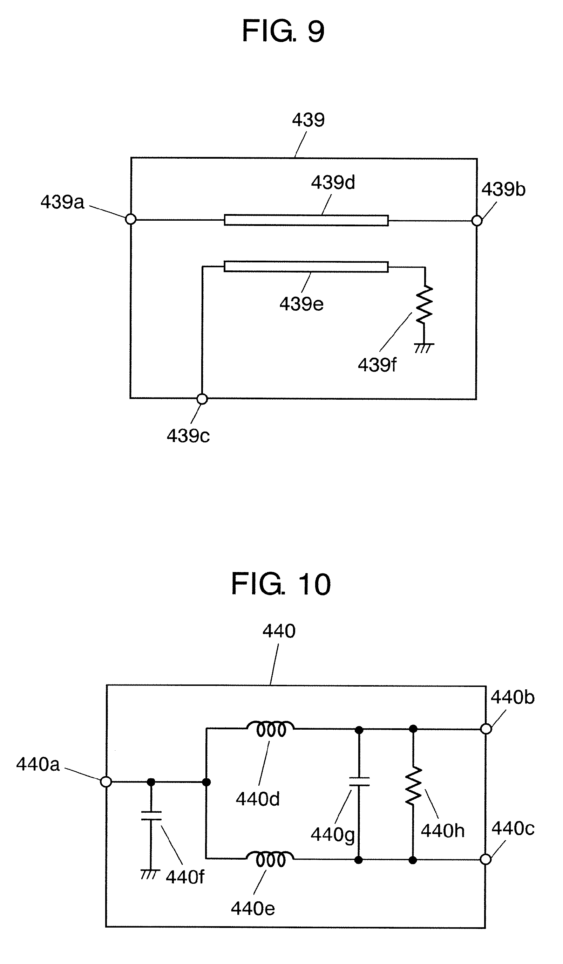

FIG. 3C is a characteristic diagram of $V_{(P1dB)}$ to current in the portable telephone device in preferred embodiment 1 of the invention. In FIG. 9C, reference numeral 94 is $V_{(P1dB)}$ to current 91, and $V_{(P1dB)}$ 7d of conventional high-frequency amplifier 7 is indicated by dotted line, and $V_{(P1dB)}$ 26d of the high-frequency amplifier 26 of the invention is indicated by solid line, respectively.

In FIG. 3A to FIG. 3C. the conventional high-frequency amplifier 7 is a semiconductor element having a maximum rating of 20 mA, and the actual current is a current value 101 (8 mA). In particular, as shown in FIG. 3C, in the conventional high-frequency amplifier 7, if the current value 101a (15 mA) is increased, $V_{(P1dB)}$ is 94a and the degree of improvement is small.

In the high-frequency amplifier 26 of the invention, by contrast, the maximum rating is 100 mA, and the actual current is a current value 101 (8 mA) or a current value 102 (40 mA). Especially at the current value 102 (40 mA), $V_{(P1dB)}$ is substantially improved to 94b.

In the high-frequency amplifier 26 of the invention, moreover, the degree of amplification and Noise Figure at current value 102 (40 mA) are hardly deteriorated as compared with the degree of amplification and Noise Figure at current value 101 (8 mA).

FIG. 4 is a characteristic diagram of bit error rate of electronic tuner to input signal level in the portable telephone device in preferred embodiment 1 of the invention. That is, in the electronic tuner 22 using this high-frequency amplifier 26, reference numeral 106 is the bit error rate (BER) which represents the reception quality of the electronic tuner 22 to transmission signal level 105 entered from the television input terminal 25. A BER 107 of electronic tuner at current value 101 (8 mA) in the high-frequency amplifier is indicated by dotted line, and a BER 108 of electronic tuner at current value 102 (40 mA) in the high-frequency amplifier is indicated by solid line.

In FIG. 4, at the BER 107 (dotted line), the BER deteriorates if larger than transmission signal level 105a. By contrast, at the BER 108 (solid line), the BER does not deteriorate if transmission signal level 105b is larger than transmission signal level 105a.

Thus, by using the semiconductor element of medium power type having excellent distortion characteristic as the high-frequency amplifier 26, if the transmission signal level is larger than the transmission signal level 105a, the current of the high-frequency amplifier 26 is set larger by the current control unit 42. As a result, in the high-frequency amplifier 26, v (P1dB) can be improved substantially without losing the Noise Figure. Thus, distortion of the high-frequency amplifier 26 can be eliminated.

On the other hand, if the transmission signal level is smaller than the transmission signal level 105a, the current of the high-frequency amplifier 26 is set smaller. As a result, the power consumption can be saved while the telephone is not used.

FIG. 5 is a circuit diagram of first filter in the portable telephone device in preferred embodiment 1 of the invention. In FIG. 5, the first filter 27 is, for example, a notch filter for eliminating a specific frequency. The first filter 27 has an input terminal 27a and an output terminal 27b. Sequentially from the input terminal 27a to the output terminal 27b, a parallel connection body 72 of inductor 72a and capacitor 72b, and a parallel connection body 73 of inductor 73a and capacitor 73b are connected in series. Further, between the junction point of parallel connection bodies 72, 73 and the ground, a series connection body 75 of inductor 75a and capacitor 75b is connected.

Herein, the parallel resonance frequency of parallel connection bodies 72, 73 and the series resonance frequency of the series connection body 75 are about 830 MHz, and the vicinity of 830 MHz is attenuated.

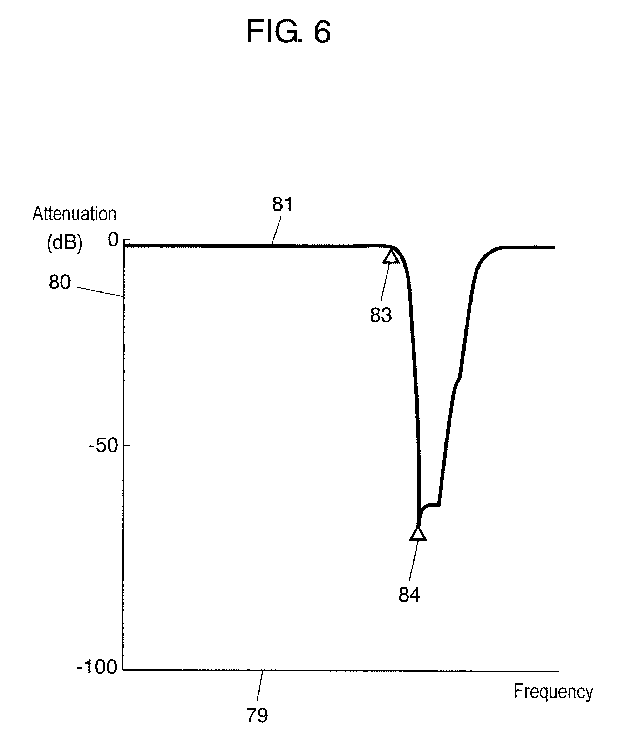

FIG. 6 is a selection characteristic diagram of first filter in the portable telephone device in preferred embodiment 1 of the invention. An axis of abscissas 79 denotes the frequency (MHz), and an axis of ordinates 80 represents the attenuation (dB). In FIG. 6, the characteristic is nearly flat up to frequency 83 of 770 MHz corresponding to a channel of highest frequency in UHF broadcast signal 66 (see FIG. 2). At frequency 84 of 830 MHz corresponding to transmission frequency 67 (see FIG. 2) of interference signal, a large attenuation of more than about 70 dB is obtained.

By using the first filter 27 having such configuration, interference by transmission signal in the high-frequency amplifier 29 and mixer 32 can be suppressed.

Next, the current control unit 42 is explained, which is designed to detect the transmission signal, and control the current value of the high-frequency amplifier 26 on the basis of the detected result.

In FIG. 1, the transmission signal from the transmitter-receiver circuit 43 is amplified in the high-frequency amplifier 26, and is supplied into the input terminal 38a of the third filter 38. The third filter 38 is composed of a series resonance circuit of capacitor 38c and inductor 38d sequentially connected from the input terminal 38a to the output terminal 38b. This series resonance frequency is set nearly equal to frequency 830 MHz of transmission signal.

A cathode of wave detector40a is connected to the output terminal 38b of the third filter 38, and an anode of wave detector 40a is connected to the ground. As a result, the transmission signal passing through the third filter 38 is detected by the wave detector 40a. The detected voltage is averaged by an integrating circuit having a resistance 40b and a capacitor 40c. The resistance 40b is, for example, 500 ohms in relation to the response time.

One end of the 500-ohm resistance 40b is connected to a junction 38e of capacitor 38c and inductor 38d. It hence prevents dumping of transmission signal of high frequency entered in the wave detector 40a. Therefore, a sufficient detected voltage is obtained in the wave detector 40a.

Suppose, for example, the resistance 40b is connected between the output terminal 38b and the input of the current control circuit 41. The series resonance frequency of the capacitor 38c and inductor 38d is matched with the frequency of transmission signal. According, the output terminal 38b is directly dumped by the resistance 40b at the frequency of transmission signal. As a result, the detected voltage is spoiled.

The voltage thus charged in the capacitor 40c is supplied in the current control circuit 41. The output of the current control circuit 41 is supplied in the current control input 26a of the high-frequency amplifier 26.

For example, if a transmission signal is present, the charged voltage in the capacitor 40c increases, and the current value of the high-frequency amplifier 26 is set larger. Or, if a transmission signal is not present, or is small, the charged voltage in the capacitor 40c decreases, and the current value of the high-frequency amplifier 26 is set smaller.

In this manner, when the transmission signal is detected, the current value of the high-frequency amplifier 26 is set larger by the current control unit 42. As a result, if the portable telephone 23 is in use, the television broadcast can be received. If a transmission signal is not present, or is small, the current of the high-frequency amplifier 26 is set smaller. As a result, while not in use, the power consumption can be saved.

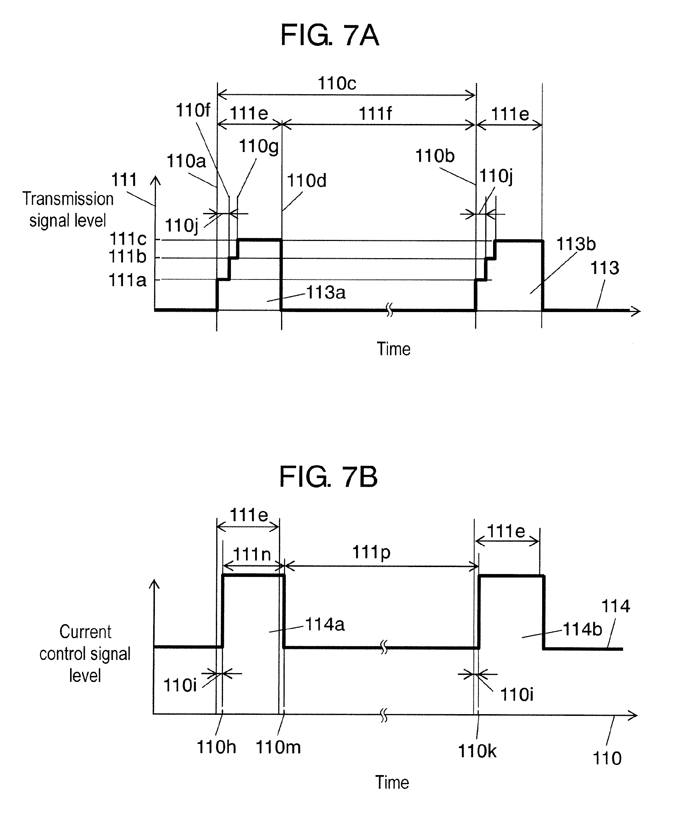

FIG. 7A is a time chart of transmission signal in the portable telephone device in preferred embodiment 1 of the invention. In FIG. 7A, the transmission signal of GSM system is a burst signal 113, and a signal 113b follows a signal 113a, and similar signals are transmitted consecutively.

A period 110c from start time 110a of signal 113a till start time 110b of signal 113b is, for example, 4600 μsec. A period 111e from start time 110a till end time 110d of signal 113a is, for example, 570 μ sec.

This signal 113a is output level 111a at time 110a, and further increases to output level 111b at time 110f, and is set in gradual steps to become final output level 111c at time 110g. Gradual setting of signal 113a is same in next signal 113b, and signals following this signal 113b.

Thus, the output level of signals 113a, 113b is set in gradual steps. The reason is as follows. That is, the power amplifier of the transmission circuit provided in the transmitter-receiver circuit 43 is composed of multiple stages, and it is controlled so that operation of multiple stages of power amplifiers may be started sequentially.

Accordingly, it is possible to suppress sudden load changes on the oscillator by the power amplifier in the transmitter-receiver circuit 43. Therefore, fluctuations of oscillator frequency of this oscillator can be suppressed.

The current control signal 114 issued from the current control unit 42 is explained. The transmission signal, or burst signal 113 is supplied into the detection circuit 40 from the input terminal 38a. The voltage detected by the wave detector 40a in this detection circuit 40 is averaged by the integrating circuit composed of resistance 40b and capacitor 40c. The average signal is supplied into the current control circuit 41.

FIG. 7B is a time chart of current control signal in the portable telephone device in preferred embodiment 1 of the invention. In FIG. 7B, a period 110i from time 110a till rise time 110h of current control signal 114a issued from the current control circuit 41 is set smaller than a period 110j from time 110a till time 110f. The relation of period 110i and period 100j in the current control signal 114a is same in the current control signal 114b.

For example, if the period 110j is 10 μsec, the period 110i must be set smaller than 10 μsec. Accordingly, for example, the capacity value of the capacitor 40c is 10 nF, and the resistance value of the resistance 40b is 500 ohms.

This period 110i is, as shown in formula (3), almost determined by time constant C × R of resistance value R of resistance 40b and capacity value C of capacitor 40c.

$$\text{Time constant } 110i = C \times R$$
$$= 10 \times 10^{-9} \times 500$$
$$= 5 \mu \sec \qquad (3)$$

where C is the capacity value (F) of the capacitor 40c, and R is the resistance value (ohms) of the resistance 40b.

Hence, the period 110i is set almost at 5 μsec.

While there is no signal other than signals 113a, 113b, the charged voltage of the capacitor 40c is discharged in a short time by the load of the current control circuit 41. That is, the burst signal 113 rises at time 110d, and the current control signal 114 becomes 0 V at time 110m.

In this manner, the rise time 110h of current control signal 114a can be started within the rise period 110j of burst signal 113a by detecting the first rising output level 111a. The fall time 110m of current control circuit 114a is determined by the fall time 110d of burst signal 113a. This current control signal 114a is same in current control signal 114b corresponding to burst signal 113b.

Thus, by using the current control signal 114 from the current control unit 42, in the period 111n corresponding to the period 111e having transmission signal, the current value of the high-frequency amplifier 26 is set larger, 40 mA, and in the period 111p corresponding to the period 111f not having transmission signal, the current value of the high-frequency amplifier 26 can be set lower, 8 mA. The period 111p is a length of time from fall time 110m of current control signal 114a till fall time 110k of current control signal 114b.

Before change from output level 111a to output level 111b of burst signal 113a, the current value of the high-frequency amplifier 26 can be set larger by using the current control signal 114. Accordingly, in the high-frequency amplifier 26, distortion due to signal 113a can be suppressed. Since the current value can be set larger only in the period 111n (570 μ sec), the power consumption can be saved substantially.

Meanwhile, the rise time 110h of current control signal 114a may be set before the rise time 110g of signal 113a.

When the transmission signal is detected, the current of the high-frequency amplifier 26 can be set larger by the current control unit 42. As a result, if the portable telephone 23 is in use, the high-frequency amplifier 26 does not generate distortion due to transmission signal, and television broadcast of high quality can be received.

Besides, since the high-frequency amplifier 26 is inserted between the television input terminal 25 and the first filter 27, deterioration of reception sensitivity can be improved.

Further, if transmission signal is not present or is small, the current of the high-frequency amplifier 26 is decreased. Hence the power consumption is saved while the telephone is not in service.

A second filter (not shown) may be inserted between the television input terminal 25 and the high-frequency amplifier 26. The second filter is supposed to suppress the transmission signal by 20 to 30 dB, and is set at a smaller suppression amount of transmission signal by the first filter 27.

For example, when the portable telephone device is further reduced in size, isolation Viso from the portable telephone antenna 24 to the television antenna 21 deteriorates further. In this case, too, the transmission signal can be suppressed by 20 to 30 dB by the second filter. Therefore, without sacrificing the reception sensitivity, the portable telephone device may be realized in a smaller size.

(Preferred Embodiment 2)

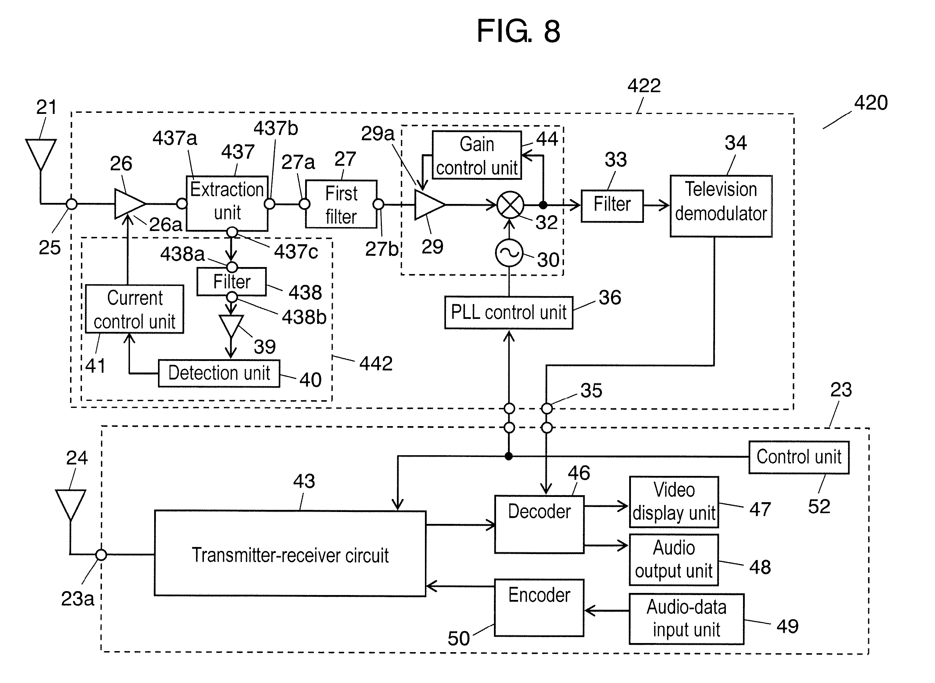

FIG. 8 is a block diagram of portable telephone device in preferred embodiment 2 of the invention. In FIG. 8, in a portable telephone device 420 in preferred embodiment 2, a current control unit 442 has a high-frequency amplifier 39 inserted between a filter 438 and a detection circuit 40. Further, an extraction circuit 437 is inserted in the output of high-frequency amplifier 26, the input of first filter 27, and the input of current control unit 442, and other structure is same as in the portable telephone device in preferred embodiment 1. Same parts as in preferred embodiment 1 are identified with same reference numerals, and specific explanation is omitted.

The portable telephone device 420 is composed of an electronic tuner 422 and a portable telephone 23. In this electronic tuner 422, an input terminal 437a of extraction circuit 437 is connected to the output of high-frequency amplifier 26. An input terminal 27a of first filter 27 is connected to an output terminal 437b of extraction circuit 437.

Further, an input terminal 438a of filter 438 is connected to an output terminal 437c of extraction circuit 437. The input of the high-frequency amplifier 39 is connected to an output terminal 438b of this filter 438. The input of detection circuit 40 is connected to the output of the high-frequency amplifier 39. The input of the current control circuit 41 is connected to the output of this detection circuit 40. The output of the current control circuit 41 is connected to a current control input 26a of the high-frequency amplifier 26.

FIG. 9 is a circuit diagram of extraction circuit using directional coupler in portable telephone device in preferred embodiment 2 of the invention. In FIG. 9, input terminal 439a, and output terminals 439b, 439c provided in the directional coupler 439 correspond respectively to input terminal 437a, and output terminals 437b, 437c of the extraction circuit 437 in FIG. 8. Between the input terminal 439a and output terminal 439b, a resonator 439d is composed, together with a resonator 439e as directional coupler disposed closely to this resonator 439d, a 50-ohm resistance 439f connected between one end of this resonator 439e and the ground, and an output terminal 439c connected to other end of the resonator 439e. Both resonators 439dd, 439e are preferred to have a length of about quarter of frequency of UHF broadcast signal.

Since the directional coupler is composed of the resonators 439d, 439e, transmission loss from the input terminal 439a to the output terminal 439b can be reduced to about 0.5 dB. The signal level issued from the output terminal 439c can be set smaller than the signal level issued from the output terminal 439b. The isolation from the output terminal 439c to the output terminal 439b can be increased to about 20 dB.

FIG. 10 is a circuit diagram of extraction circuit using power distributor in portable telephone device in preferred embodiment 2 of the invention. In FIG. 10, input terminal 440a, and output terminals 440b, 440c provided in the power distributor 440 correspond respectively to input terminal 437a, and output terminals 437b, 437c of the extraction circuit 437. Between the input terminal 440a and output terminal 440b, an inductor 440d is connected. Between the input terminal 440a and output terminal 440c, an inductor 440e is connected. Between the input terminal 440a and the ground, a capacitor 440f is connected. Between the output terminals 440b, 440c, a capacitor 440g and resistance 440h are connected. The inductance of the inductor 440d is nearly 12 nH. The inductance of the inductor 440e is nearly 12nH. The capacity value of the capacitor 440f is nearly 3 pH. The capacity value of the capacitor 440g is nearly 6 pH. The resistance value of the resistance 440h is nearly 100 ohms.

In this way, the signal from the input terminal 440a is distributed into two portions by the power distributor 440 and issued from the output terminals 440b, 440c. Between the output terminals 440b, 440c, a great isolation of nearly 20 dB can be obtained.

Thus, by the high-frequency amplifier 39, directional coupler 439 or power distributor 440, a sufficient isolation can be assured from the detection circuit 40 to the input terminal 27a of the first filter 27. Therefore, if a nonlinear distortion component in the detection circuit 40 due to large transmission signal is superimposed on the UHF broadcast signal, flow of this UHF broadcast signal into the signal line of the input of the first filter 27 can be prevented. Hence, if the portable telephone 23 is being used, interference does not occur, and television broadcast can be received at high quality.

In order to assure the isolation from the detection circuit 40 to the input terminal 27a of the first filter 27, instead of using the extraction circuit 437, an isolator may be inserted between the junction point of output of the high-frequency amplifier 26 and the input terminal 27a of the first filter 27 and the detection circuit 40, and the same effects can be obtained.

(Preferred Embodiment 3)

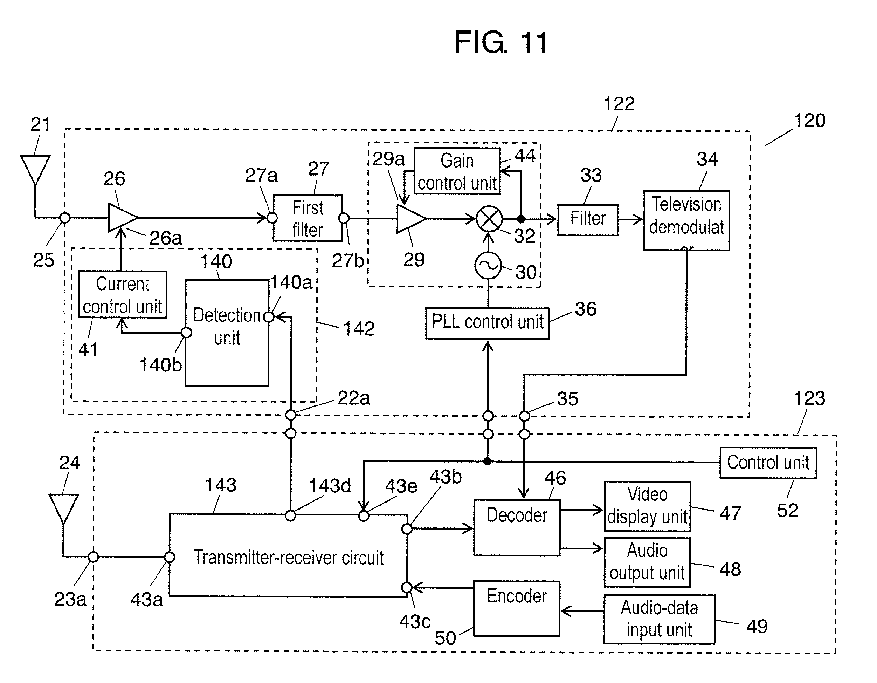

FIG. 11 is a block diagram of portable telephone device in preferred embodiment 3 of the invention. In FIG. 11, a portable telephone device 120 includes an electronic tuner 122 for receiving television broadcast signals (VHF broadcast signal, UHF broadcast signal) from a television antenna 21, and a portable telephone 123 connected to a portable telephone antenna 24. Same parts as in preferred embodiment 1 are identified with same reference numerals, and specific explanation is omitted.

The electronic tuner 122 is explained in the first place. The electronic tuner 122 includes a television input terminal 25 connected to the television antenna 21, a high-frequency amplifier 26 connected to the television input terminal 25 and having a current control input 26a for controlling a current value, a first filter 27 to which the output of this high-frequency amplifier 26 is connected for suppressing other signals than television broadcast signals, a high-frequency amplifier 29 to which the output of this first filter 27 is connected and having a gain control input 29a for controlling the gain, a mixer 32 for receiving the output of this high-frequency amplifier 29 at one input and receiving the output of an oscillator 30 at other input, a filter 33 to which the output of this mixer 32 is connected for passing an intermediate frequency signal, a television demodulator 34 to which the output of this filter 33 is connected, a television output terminal 35 for receiving a TS (transport stream) signal from this television demodulator 34, a PLL control circuit 36 for controlling the PLL of the oscillator 30, a transmission signal input terminal 22a for receiving part of the transmission signal of the portable telephone 23, a detection circuit 140 for receiving the transmission signal from this transmission signal input terminal 22a from an input terminal 140a and detecting this transmission signal, and a current control circuit 41 connected between an output terminal 140b of this detection circuit 140 and the current control input 26a, for controlling the current value of the high-frequency amplifier 26.

Herein, the current control unit 142 is composed of the detection circuit 140, and current control circuit 41. The output of the mixer 32 is connected to the input of a gain control circuit 44. The output of this gain control circuit 44 is connected to the gain control input 29a.

Operation is explained about the electronic tuner 122 having such configuration. The television signal received in the antenna 21 is fed into the high-frequency amplifier 26. The output signal from the high-frequency amplifier 26 is supplied into the first filter 27 for suppressing the transmission signal issued from the portable telephone.

The output signal from the first filter 27 is controlled in gain by the high-frequency amplifier 29,an d is put into on input of the mixer 32, and the output signal from the oscillator 30 is supplied into other input.

An intermediate signal of, for example, from 57 MHz issued from the mixer 32 is put into the filter 33, and interference signals other than desired signals are suppressed. The oscillator 30 is controlled in the frequency by the control signal issued from the PLL control circuit 36.

The gain control voltage issued from the gain control circuit 44 is supplied into the gain control input 29a of the high-frequency amplifier 29. Hence the gain is controlled so that the output signal from the mixer 32 may be at a constant level.

As the input to the gain control circuit 44, meanwhile, the output of the filter 33 may be supplied. In this case, it is possible to suppress the transmission signal or interference signals of adjacent channels by the filter 33, and effects of interference signals on gain control can be reduced.

The output signal of the mixer 32 is sufficiently suppressed in the interference signal by the filter 33, and is fed into the television demodulator 34. The TS signal issued from the television demodulator 34 is issued from the television output terminal 35.

In this manner, the television broadcast signal entered in the television input terminal 25 is amplified in the high-frequency amplifier 26, and the gain is controlled in the high-frequency amplifier 29, the frequency is converted in the mixer 32, and the signals suppressed in the transmission signal or interference signal by the first filter 27 and filter 33 are supplied into the television demodulator 34. The TS signal demodulated in the television demodulator 34 is issued from the television output terminal 35.

The portable telephone 123 is explained. This portable telephone 123 includes an input-output terminal 23a to which a portable telephone antenna 24 is connected, a transmitter-receiver circuit 43 to which the input-output circuit 23a is connected by way of an input-output terminal 43a, a demodulator 46 for demodulating the input signal, to which an output terminal 43b of this transmitter-receiver circuit 43 and a television output terminal 35 of the television demodulator 34 are connected, a video display unit 47 and an audio output unit 48 connected to the video output and audio output from the demodulator 46 respectively, an audio-data input unit 49 receiving the audio and data signal, an encoder 50 for encoding the audio and data signal connected between the audio-data input unit 49 and the input terminal 43c of the transmitter-receiver circuit 143, and a control unit 52 for controlling the transmitter-receiver circuit 143 and the PLL control circuit 36.

An output terminal 143d to which a part of transmission signal provided in the transmitter-receiver circuit 143 is issued is connected to the transmission signal input terminal 22a.

Operation is described about the portable telephone 123 having such configuration. By a control signal from the control unit 52, the portable telephone 123 is set in service mode. As a result, the transmission signal issued from the transmitter-receiver circuit 143 of the portable telephone 123 is transmitted from the portable telephone antenna 24.

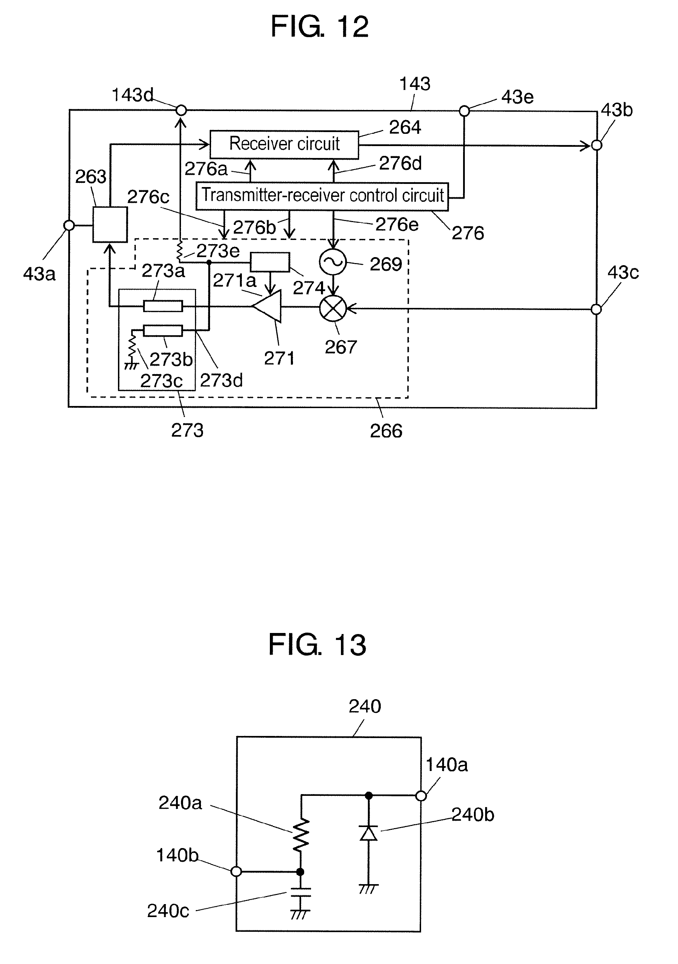

FIG. 12 is a block diagram of transmitter-receiver circuit in portable telephone device in preferred embodiment 3 of the invention. In FIG. 12, the transmitter-receiver circuit 143 used in the portable telephone 123 includes an input-output terminal 43a connected to the input-output terminal 23a, an output terminal 43b for supplying a decoding signal to the decoder 46, an input terminal 43c for receiving the signal from the encoder 50, an output terminal 143d for issuing part of transmission signal, and an input terminal 43e for receiving the control signal from the control unit 52.

The transmitter-receiver circuit 143 includes an antenna switch 263 having a common terminal connected to the input-output terminal 43a, a receiver circuit 264 connected between one end of this antenna switch 263 and the output terminal 43b, a transmitter circuit 266 connected between the input terminal 43c and other terminal of the antenna switch 263, and a transmitter-receiver control circuit 276 for receiving the control signal from the input terminal 43e and controlling the receiver circuit 264 and transmitter circuit 266.

Outputs 276a, 276b, 276c, 276d, 276e are provided in the transmitter-receiver control circuit 276.

The supply voltage issued from the output 276a is supplied into the receiver circuit 264, and the receiver circuit 264 is set in reception state. The supply voltage issued from the output 276b is supplied into the transmitter circuit 266, and the transmitter circuit 266 is set in transmission state. The control voltage issued from the output 276c is supplied into the control input of power control circuit (not shown) of the power amplifier 271, and this power amplifier 271 is set in transmission signal amplifying state. This control voltage from the output 276c may be also issued from other control circuit (not shown) than the transmitter-receiver control circuit 276. The control signals issued from the outputs 276d, 276e are supplied into an oscillator (not shown) in the receiver circuit 264 and the oscillator 269, and the individual oscillation frequencies can be determined.

The transmitter circuit 266 includes a mixer 267 having an input terminal 43c connected at one input, an oscillator 269 connected to other input of this mixer 267, a power amplifier 271 connected to the output of the mixer 267, a resonator 273a connected between the output of this power amplifier 271 and other terminal of antenna switch 263, a resonator 273b as directional coupler disposed closely to this resonator 273a, a 50-ohm resistance 273c connected between one end of this resonator 273b and the ground, a gain control circuit 274 connected between output 273d as other end of the resonator 273b and a gain control input 271a of the power amplifier 271, and a resistance 273e connected between output 273d of the resonator 273b and output 43d.

A directional coupler 273 is composed of resonators 273a, 273b, and resistance 273c.

The resonators 273a, 273b have a length of about quarter wavelength of transmission signal.

The resistance 273e may be also inserted between the output terminal 143d and input terminal 140a of the detection circuit 140.

The operation of the transmitter-receiver circuit 143 having such configuration is explained by referring to FIG.

12. In FIG. 12, the transmitter-receiver circuit 143 is set in transmission state or reception state by the control signal from the input terminal 43e, or the frequency of reception signal or the frequency of transmission signal is determined.

For example, in reception state, the reception signal from the input-output terminal 43a is decoded in the receiver circuit 264, and issued from the output terminal 43b. In transmission state, the coded signal from the input terminal 43c is supplied in one input of the mixer 267. In other input of the mixer 267, the oscillation signal of the oscillator 269 is supplied.

The transmission signal of heightened frequency issued from the mixer 267 is fed into the power amplifier 271. The transmission signal issued from the power amplifier 271 is fed into the directional coupler 273. The transmission signal issued from the directional coupler 273 is sent out from the input-output terminal 43a by way of the antenna switch 263.

From the output 273d of the directional coupler 273, part of the entered transmission signal is extracted. The extracted transmission signal is supplied into the input of the gain control circuit 274. The output signal of the gain control circuit 274 is fed into the gain control input 271a of the power amplifier 271. As a result, the power amplifier 271 is controlled in the gain so that the output level may be constant.

The transmission signal issued from the power amplifier 271 is fed into the directional coupler 273. From the output 273d of the directional coupler 273, part of the transmission signal is issued, and is sent out from the output terminal 143d. Part of the transmission signal sent out from the output 273d is supplied into the output terminal 143d by way of resistance 273e. This output terminal 143d is wired to the input terminal 140a of the detection circuit 140 of the current control unit 142, for example, by print pattern.

The print pattern has an equivalent capacity occurring between the equivalent inductance and the ground, and hence has impedance fluctuations relating to the frequency. Such impedance fluctuations can be prevented by the resistance 273e having a resistance value of, for example, 4.7 ohms to 100 ohms.

This resistance 273e can suppress impedance fluctuations due to frequency between the output 273d of the directional coupler 273 and the input terminal 140a of the detection circuit 140. Therefore, transmission power of uniform level is issued from the output terminal 143 d of the transmitter circuit 266.

The transmission signal from the output terminal 143d is fed into the current control unit 142. The operation of the current control unit 42 is explained by referring to FIG. 13.

FIG. 13 is a circuit diagram of detection circuit in portable telephone device in preferred embodiment 3 of the invention. In FIG. 13, the detection circuit 240 includes an input terminal 140a and an output terminal 140b. A resistance 240a is connected between the input terminal 140a and output terminal 140b.

Between the input terminal 140a and the ground, a wave detector 240b is connected so that the cathode may come to the input terminal 140a side. A capacitor 240c is connected between the output terminal 140b and the ground.

The transmission signal supplied in the input terminal 140a of the detection circuit 240 is detected by the wave detector 240b. The detected voltage is averaged by an integrating circuit composed of a resistance 240a and a capacitor 240c. The averaged signal is supplied into the current control circuit 41 by way of the output terminal 140b.

For example, if the transmission signal from the portable telephone 123 is present, this transmission signal is detected by the wave detector 240b, and the charged voltage in the capacitor 240c increases. When such large charged voltage is supplied in the current control circuit 41, the current value of the high-frequency amplifier 26 is set larger.

If the transmission signal from the portable telephone 123 is not present, or is small, the charged voltage in the capacitor 240c decreases. When such small charged voltage is supplied in the current control circuit 41, the current value of the high-frequency amplifier 26 is set smaller.

In this way, when transmission signal from the portable telephone 23 is detected, the current of the high-frequency amplifier 26 is set larger by the current control unit 42. As a result, the television broadcast can be received if the portable telephone 23 is in use. When the transmission signal from the portable telephone 23 is not present or is small, the current of the high-frequency amplifier 26 is set smaller. As a result, the power consumption can be saved while not in use. Or while the portable telephone 23 is not used, the current control unit 42 sets the current of the high-frequency amplifier 26 smaller. As a result, the power consumption can be saved.

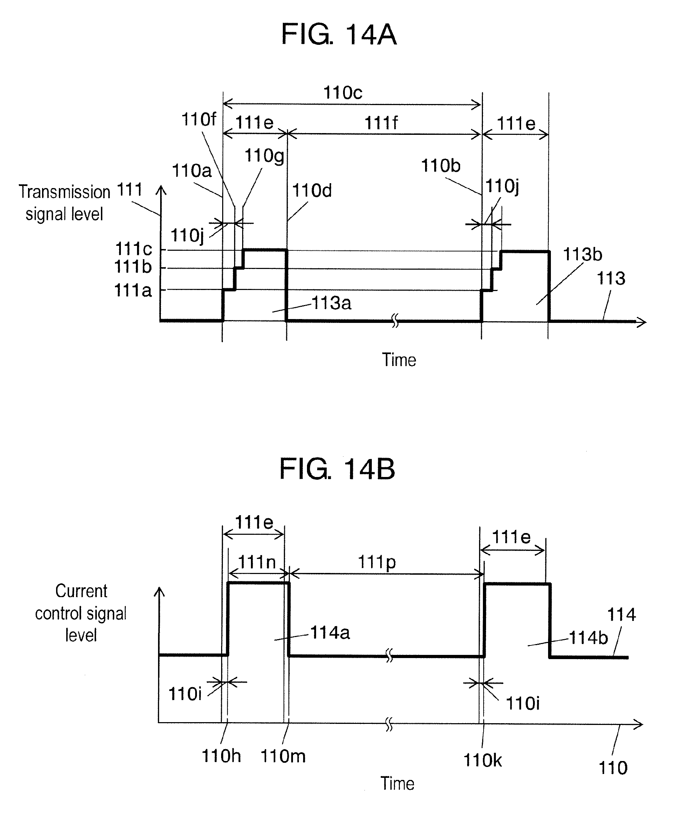

FIG. 14A is a time chart of transmission signal in portable telephone device in preferred embodiment 3 of the invention. In FIG. 14A, the transmission signal of GSM system is a burst signal 113, and a signal 113b follows a signal 113a, and similar signals are transmitted consecutively.

A period 110c from start time 110a of signal 113a till start time 110b of signal 113b is, for example, 4600 $\mu$sec. A period 111e from start time 110a till end time 110d of signal 113a is, for example, 570 $\mu$sec.

This signal 113a is output level 111a at time 110a, and further increases to output level 111b at time 110f, and is set in gradual steps to become final output level 111c at time 110g. Gradual setting of signal 113a is same in next signal 113b, and signals following this signal 113b.

Thus, the output level of signals 113a, 113b is set in gradual steps. The reason is as follows. That is, the power amplifier of the transmission circuit provided in the transmitter-receiver circuit 43 is composed of multiple stages, and it is controlled so that operation of multiple stages of power amplifiers may be started sequentially.

Accordingly, it is possible to suppress sudden load changes on the oscillator by the power amplifier in the transmitter-receiver circuit 43. Therefore, fluctuations of oscillator frequency of this oscillator can be suppressed.

FIG. 14B is a time chart of current control signal in portable telephone device in preferred embodiment 3 of the invention. In FIG. 14B, current control signals 114a, 114b must rise or fall in a short time corresponding to burst signals 113a, 113b, respectively. Rising in short time contributes to improvement of distortion due to transmission signal in the high-frequency amplifier 26. Falling in short time contributes to reduction of power consumption in the high-frequency amplifier 26.

Accordingly, the rise time 110h of current control signal 114a is set within period 110j from time 1110a till time 110f of burst signal 113a. This relation is same in the current control signal 114b and burst signal 113b. The period from time 110a till time 110h is supposed to be period 110i.

For example, if the period 110j is 10 psec, the period 110i must be set smaller than 10 $\mu$sec. Accordingly, for example, the capacity value of the capacitor 240c is10 nF, and the resistance value of the resistance 240a is 500 ohms.

This period 110i is, as shown in formula (4), almost determined by time constant C $\times$ R of resistance value R of resistance 240a and capacity value C of capacitor 240c. Hence, the period 110i is set almost at 5 $\mu$sec.

$$\text{Time constant } 110i = C \times R$$

$$= 10 \times 10^{-9} \times 500$$

$$= 5 \mu \sec \qquad\qquad (4)$$

where C is the capacity value (F) of the capacitor 240c, and R is the resistance value (ohms) of the resistance 240a.

While there is no signal other than signals 113a, 113b, the charged voltage of the capacitor 240c is discharged in a short time by the load of the current control circuit 41. The relation of period 1101 and period 110j in the current control signal 114a is same in the current control signal 114b.

In this manner, the rise time 110h of current control signal 114a can be started within the rise period 110j of burst signal 113a by detecting the first rising output level 111a. The rise time 110m of current control circuit 114a is determined by the rise time 110d of burst signal 113a.

By using the current control signal 114a, the current value of the high-frequency amplifier 26 is set larger. Therefore, distortion by transmission signal of the high-frequency amplifier 26 can be suppressed.

This is the same in the current control signal 114b corresponding to the burst signal 113b, and the rise time 110k of current control signal 114b can be started within the first rise period 110j of burst signal 113b.

In this manner, by using the current control signal from the current control unit 142, the current value of the high-frequency amplifier 26 is increased to 40 mA in period 111n corresponding to period 111e having transmission signal, and the current value of the high-frequency amplifier 26 is decreased to 8 mA in period 111p corresponding to period 111f not having transmission signal.

Period 111p is a length of time from fall time 110m of current control signal 114a till rise time 110k of current control signal 114b.

The rise time 110h of current control signal 114a may be before the rise time 110g of signal 113a.

Thus, transmission signals from the portable telephone 123, that is, burst signals 113a, 113b are detected in the detection circuit 140. The detected signal is entered in the current control unit 42, and the current of the high-frequency amplifier 26 is set larger. As a result, in the high-frequency amplifier 26, distortion by transmission signal can be suppressed, and if the portable telephone 23 is in service, television broadcast can be received at high quality

If the transmission signal is not present, or is small, the current of the high-frequency amplifier 26 is set smaller by the current control unit 142. Therefore, while not in use, the power consumption can be saved substantially.

Further, the high-frequency amplifier 26 is inserted between the television input terminal 25 and the first filter 27. Hence, signal loss due to first filter 27 does not occur, and deterioration of reception sensitivity can be improved.

The level of detection signal issued from the output terminal 140b of the detection circuit 140 increases depending on the size of the burst signal 113. Depending on the size of this detection signal, the current value of the high-frequency amplifier 26 can be controlled by the current control circuit 41. Thus, the current value of the high-frequency amplifier 26 can be optimized depending on the burst signal level, and the current can be controlled efficiently.

Moreover, a second filter (not shown) may be inserted between the television input terminal 25 and the high-frequency amplifier 26. The second filter is supposed to suppress the transmission signal by 20 to 30 dB, and may be used by setting smaller than the suppression amount of transmission signal by the first filter 27.

For example, when the portable telephone device is further reduced in size, isolation Viso from the portable telephone antenna 24 to the television antenna 21 deteriorates further. In this case, too, the transmission signal can be suppressed by 20 to 30 dB by the second filter. Therefore, without sacrificing the reception sensitivity, the portable telephone device may be realized in a smaller size.

Meanwhile, the detection circuit 140 or current control unit 142 may be built in the portable telephone 123. As a result, the transmission signal will not leak into the electronic tuner 122, and interference by transmission signal does not occur.

(Preferred embodiment 4)

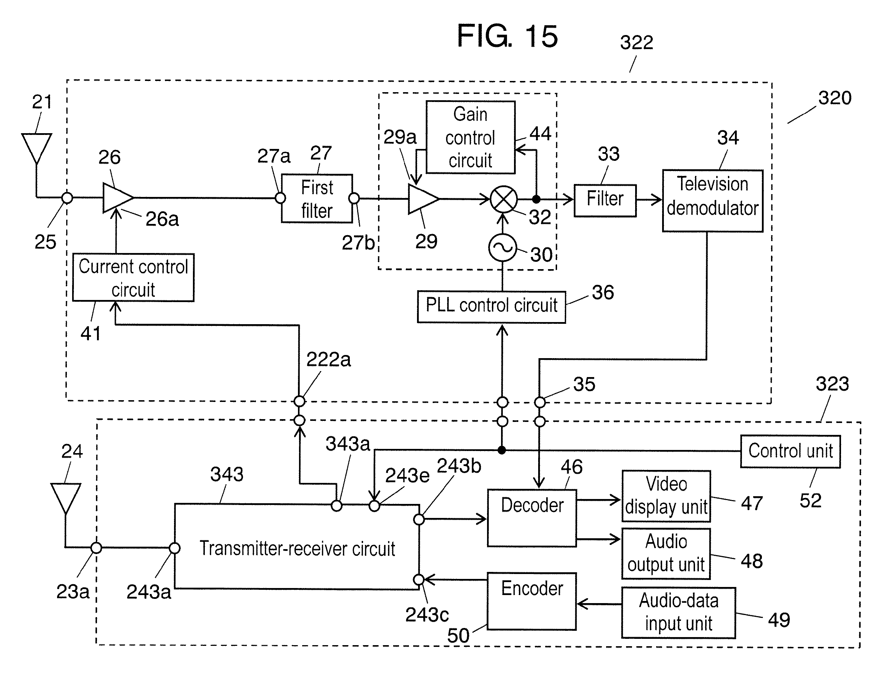

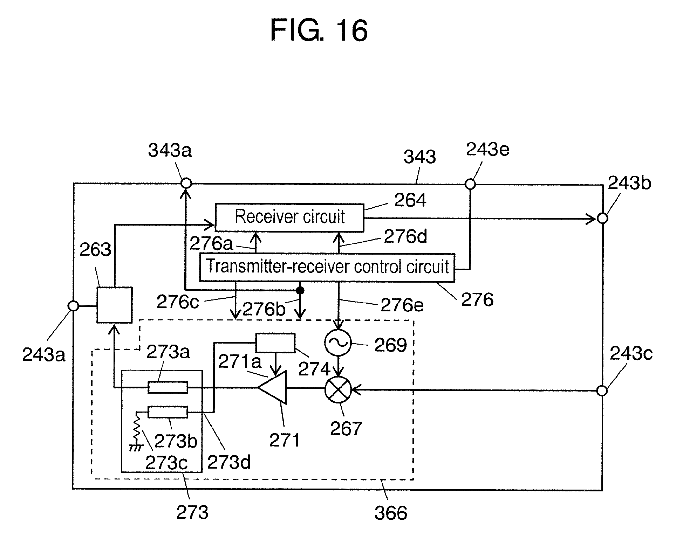

FIG. 15 is a block diagram of portable telephone device in preferred embodiment 4 of the invention. FIG. 16 is a block diagram of transmitter-receiver circuit in portable telephone device in preferred embodiment 4 of the invention.

In the portable telephone device in preferred embodiment 3, the detection signal to be entered in the current control circuit 41 is supplied from the output terminal 140b of the detection circuit 140. In the portable telephone device 320 in preferred embodiment 4, by contrast, as shown in FIG. 16, the supply voltage from the output 276b of the transmitter-receiver control circuit 276 is directly supplied to the input of the current control unit 41. The supply voltage from the output 276b can set a transmitter circuit 366 in active state.

By using the supply voltage supplied into the transmitter circuit 366, the current of the high-frequency amplifier 26 can be controlled. It is therefore free from effects of disturbance by distribution of transmission signal from the portable telephone 323, and wiring is easier. Same parts as in preferred embodiment 3 are identified with same reference numerals, and specific description is omitted.

In FIG. 15, the portable telephone device 320 includes an electronic tuner 322 and a portable telephone 323. In the electronic tuner 322, a current control unit 41 is connected between a current control input 26a of high-frequency amplifier 26 and an input terminal 222a.

In FIG. 16, a transmitter-receiver circuit 343 includes an input-output terminal 243a connected to the input-output terminal 23a, an output terminal 243b for supplying a signal to be decoded to the decoder 46, an input terminal 243c for receiving a signal from the encoder 50, an input terminal 243e connected to a transmitter-receiver control circuit 276 for receiving a control signal, and an output terminal 343a connected to the output 276b of the transmitter-receiver control circuit 276.

The transmitter-receiver circuit 343 includes an antenna switch 263 having a common terminal connected to the input-output terminal 243a, a receiver circuit 264 connected between one terminal of this antenna switch 263 and the output terminal 243b, a transmitter circuit 366 connected between the input terminal 243c and other terminal of the antenna switch 263, and a transmitter-receiver control circuit 276 for receiving the control signal from the input terminal 243e and controlling the receiver circuit 264 and transmitter circuit 366. The transmitter-receiver control circuit 276 is provided with outputs 276a, 276b, 276c, 276d, 276e.

The supply voltage issued from the output 276a is supplied into the receiver circuit 264, and the receiver circuit 264 is set in reception state. The supply voltage issued from the output 276b is supplied into the transmitter circuit 366, and the transmitter circuit 366 is set in transmission state.

The control voltage issued from the output 276c is supplied into the power amplifier 271, and this power amplifier 271 is set in transmission signal amplifying state. This control voltage from the output 276c may be also issued from other control circuit (not shown) than the transmitter-receiver control circuit 276.

The control signals issued from the outputs 276d, 276e are supplied into an oscillator (not shown) in the receiver circuit 264 and the oscillator 269, and the individual oscillation frequencies can be determined.

The transmitter circuit 366 includes a mixer 267 having an input terminal 243c connected at one input, an oscillator 269 connected to other input of this mixer 267, a power amplifier 271 connected to the output of the mixer 267, a resonator 273a connected between the output of this power amplifier 271 and other terminal of antenna switch 263, a resonator 273b as directional coupler disposed closely to this resonator 273a, a 50 ohm resistance 273c connected between one end of this resonator 273b and the ground, a gain control circuit 274 connected between output 273d as other end of the resonator 273b and a gain control input 271a of the power amplifier 271, and a resistance 273e connected between output 273d of the resonator 273b and output 43d.

A directional coupler 273 is composed of resonators 273a, 273b, and resistance 273c. The resonators 273a, 273b have a length of about quarter wavelength of transmission signal.

In the transmitter-receiver circuit 343, the control signal from the input terminal 243e is supplied into the transmitter-receiver control circuit 276. The supply voltage issued from the output 276b of this transmitter-receiver control circuit 276 is supplied into the power input of the transmitter circuit 366 and the output terminal 343a. In the output terminal 343a, instead of the output 276b, the output 276c may be also connected.

The supply voltage from the output terminal 343a is supplied into the current control circuit 41. The output of the current control circuit 41 is supplied into the current control input 26a of the high-frequency amplifier 26.

Same as in preferred embodiment 3 shown in FIGS. 14A, 14B, the rise time 110h of current control signal 114a in preferred embodiment 4 nearly coincides with the rise time 110a of burst signal 113a, and the fall time 110m nearly coincides with the rise time 110a of burst signal 113a. It is the same in the relation of current control signal 114b and burst signal 113b.

In this manner, by the supply voltage from the output 276b of the transmitter-receiver control circuit 276, the transmitter circuit 366 is set in transmission state, and a transmission signal is issued. At the same time, the supply voltage from the output 276b is fed into the current control input 26a of the high-frequency amplifier 26 by way of the current control circuit 41, and the current value of the high-frequency amplifier 26 is set larger. As a result, if the portable telephone 323 is in service, the high-frequency amplifier 26 does not generate distortion due to transmission signal, and television broadcast can be received at high quality.

If the transmission signal is not present, or is small, the current of the high-frequency amplifier 26 is set smaller. Hence, power consumption can be saved while not in use.

The portable telephone device 320 having such configuration has same effects as the portable telephone device 120 in preferred embodiment 3. Same effects are obtained if the current control circuit 41 is built in the portable telephone device 320.

(Preferred Embodiment 5)

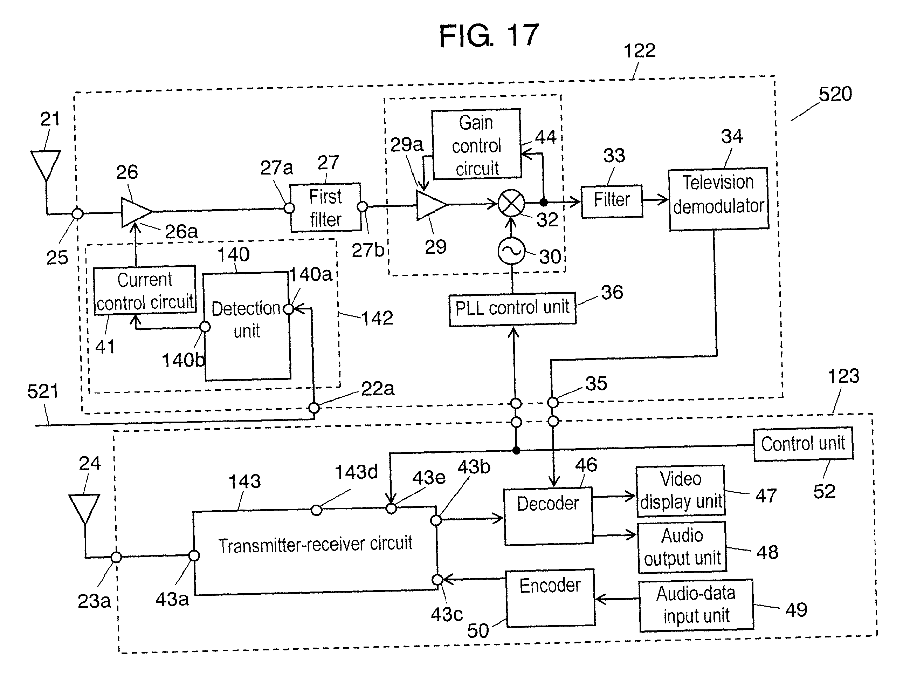

FIG. 17 is a block diagram of portable telephone device in preferred embodiment 5 of the invention.

In preferred embodiment 3, the transmission signal to be entered in the current control circuit 142 is supplied from the output terminal 143d of the transmitter-receiver circuit 143 by way of transmission signal input terminal 22a. In the portable telephone device in preferred embodiment 5, by contrast, the transmission signal input terminal 22a is provided with a pickup antenna 421. This pickup antenna 521 can receive and utilize part of the transmission signal sent from the transmitter-receiver circuit 143. Same parts as in preferred embodiment 3 are identified with same reference numerals, and specific description is omitted.

In FIG. 17, the portable telephone device 520 includes an electronic tuner 122 and a portable telephone 123. In the transmission signal input terminal 22a of the electronic tuner 122, a pickup antenna 521 for receiving part of transmission signal is connected. As the pickup antenna 521, print pattern or micro strip line can be used.

The pickup antenna 521 is provided for receiving part of the transmission signal issued from the portable antenna 24. The pickup antenna 421 is required to be small in size, and be capable of enhancing the reception sensitivity of transmission signal.

The pickup antenna 521 can be reduced in size and enhanced in reception sensitivity by the following method.

For example, part of pickup antenna 521 is disposed at least in parallel to the portable antenna 24 for issuing transmission signal. Hence, the pickup antenna 521 can stably receive the transmission signal from the portable antenna 24.

Further, for example, the pickup antenna 521 is disposed more closely to the portable antenna 24 from the television antenna 21. As a result, the pickup antenna 521 can receive the transmission signal from the portable antenna 24 at higher sensitivity.

The length of the pickup antenna 521 is set about quarter of the wavelength of transmission signal. Hence, the pickup antenna 521 can receive the transmission signal from the portable antenna 24 at higher sensitivity. This reception level is reduced and optimized by shortening the length of the pickup antenna 521.

Thus, while the portable telephone 123 is being used, part of transmission signal is received in the pickup antenna 421, and is detected by the detection circuit 40. The detected voltage is supplied into the current control input 26a of the high-frequency amplifier 26 by way of the current control circuit 41, and the current value of the high-frequency amplifier 26 is set larger.

Hence, if the portable telephone 123 is in use, the high-frequency amplifier 26 does not cause distortion by the transmission signal, and television broadcast can be received at high quality.

If transmission signal is not present or is small, the current of the high-frequency amplifier 26 is set smaller. As result, while not in use, the power consumption can be saved.

The portable telephone device 520 having such configuration also brings about the same effects as the portable telephone device 120 in preferred embodiment 3.

The electronic tuner of the invention can receive television broadcast signals without being disturbed by the portable telephone, and is hence very useful as electronic tuner built in the portable telephone device.

**Claims**

1.  An electronic tuner built in a portable telephone device,
    wherein the electronic tuner comprises:

a television input terminal for receiving a television broadcast signal,
a first filter for receiving the signal supplied in the television input terminal and blocking the transmission signal from the portable telephone of the portable telephone device,
a mixer for receiving the output from the first filter at one input,
an oscillator connected to other input of the mixer,
a television output terminal for receiving the output of the mixer,
a first high-frequency amplifier inserted between the television input terminal and the first filter, and having a current control input for controlling the current value, and
a current control unit for controlling the current of the first high-frequency amplifier, and
the current control unit sets the current of the first high-frequency amplifier larger while the portable telephone is sending the transmission signal.

2. The electronic tuner of claim 1,
wherein the current control unit is inserted between the output of the first high-frequency amplifier and the current control input, and controls the current of the first high-frequency amplifier by detecting the transmission signal.

3. The electronic tuner of claim 2,
wherein the current control unit detects the first rising signal of the transmission signals rising gradually, and controls the current of the first high-frequency amplifier.

4. The electronic tuner of claim 2, being an electronic tuner used in portable telephone device of GSM system,
wherein the current control unit sets the current of the first high-frequency amplifier larger while the burst signal transmitted from the portable telephone is present, and sets current of the first high-frequency amplifier smaller while the burst signal is not present.

5. The electronic tuner of claim 2,
wherein the first filter is composed of a notch filter for suppressing the transmission signal.

6. The electronic tuner of claim 2, further comprising:

a second filter for suppressing the transmission signal connected between the television input terminal and the input of first high-frequency amplifier,

wherein the suppression amount of transmission signal by the second filter is set smaller than the suppression amount of transmission signal by the first filter.

7. The electronic tuner of claim 2,
wherein the current control unit comprises:

a third filter for passing the transmission signal,
a detection circuit for detecting the transmission signal from the third filter, and
a current control circuit connected between the output of the detection circuit and the current control input of the first high-frequency amplifier for controlling the current of the first high-frequency amplifier.

8. The electronic tuner of claim 2, further comprising:

an extraction circuit inserted between the output of the first high-frequency amplifier and the input of the first filter, and having an output terminal for issuing part of the output signal of the first high-frequency amplifier,

wherein the output terminal of the extraction circuit is connected to the input of the current control unit.

9. The electronic tuner of claim 2, further comprising:

a power distributor inserted between the output of the first high-frequency amplifier and the input of the first filter, and having an output terminal for issuing a distributed signal of the output signal of the first high-frequency amplifier,

wherein the output terminal of the power distributor is connected to the input of the current control unit.

**10.** The electronic tuner of claim 1, further comprising:

an isolator inserted between the output of the first high-frequency amplifier and the input of the first filter, and having an output terminal for issuing part of the output signal of the first high-frequency amplifier,

wherein the output terminal of the isolator is connected to the input of the current control unit.

**11.** A portable telephone device using the electronic tuner of claim 2.

**12.** The electronic tuner of claim 1, further comprising:

a transmission signal input terminal for receiving part of the transmission signal,

wherein the current control unit detects part of the transmission signal from the transmission signal input terminal, and supplies a current control signal to the current control input.

**13.** The electronic tuner of claim 12,
wherein the current control unit detects the first rising signal of the transmission signals rising gradually, and controls the current of the first high-frequency amplifier.

**14.** The electronic tuner of claim 12, being an electronic tuner used in portable telephone device of GSM system, wherein the current control unit sets the current of the first high-frequency amplifier larger while the burst signal transmitted from the portable telephone is present, and sets current of the first high-frequency amplifier smaller while the burst signal is not present.

**15.** The electronic tuner of claim 12,
wherein the first filter is composed of a notch filter for suppressing the transmission signal.

**16.** The electronic tuner of claim 12, further comprising:

a second filter for suppressing the transmission signal connected between the television input terminal and the input of first high-frequency amplifier,

wherein the suppression amount of transmission signal by the second filter is set smaller than the suppression amount of transmission signal by the first filter.

**17.** The electronic tuner of claim 12,
wherein a pickup antenna for receiving part of the transmission signal is connected to the transmission signal input terminal for receiving the transmission signal.

**18.** The electronic tuner of claim 12,
wherein the current control unit includes a detection circuit for detecting the transmission signal supplied in the transmission signal input terminal, and a current control circuit connected between the output of the detection circuit and the current control input of the first high-frequency amplifier, for controlling the current of the first high-frequency amplifier.

**19.** A portable telephone device incorporating a portable telephone and the electronic tuner of claim 12, wherein the transmitter circuit built in the portable telephone includes:

a power amplifier for amplifying the transmission signal,
a first resonator inserted between the output of the power amplifier and the portable telephone antenna,
a second resonator formed as a directional coupler disposed closely to the first resonator,
a first resistance connected between one end of the second resonator and the ground, and
a gain control circuit connected between other end of the second resonator and the gain control input of the power amplifier, and
other end of the second resonator is connected to the transmission signal input terminal.

FIG. 1

# FIG. 2

# FIG. 3A

Degree of amplification

26b

92

7b

101          102      Current

91

# FIG. 3B

Noise Figure

7c          26c

93

101          102      Current

91

# FIG. 3C

$V_{(P1dB)}$

26d

94b

94

94a

7d

101  101a      102      Current

91

# FIG. 4

# FIG. 5

# FIG. 6

# FIG. 7A

Time

# FIG. 7B

Time

FIG. 8

# FIG. 9

# FIG. 10

FIG. 11

# FIG. 12

# FIG. 13

# FIG. 14A

# FIG. 14B

FIG. 15

320

322

Television demodulator 34

Filter 33

Gain control circuit 44

32

30

29 29a

First filter 27 27a 27b

26 26a

21

25

Current control circuit 41

PLL control circuit 36

35

222a

323

Control unit 52

Video display unit 47

Audio output unit 48

Audio-data input unit 49

Decoder 46

Encoder 50

Transmitter-receiver circuit 343

243e 243b

343a

243a

243c

24

23a

# FIG. 16

# FIG. 17

EP 1 921 755 A2

FIG. 18   Prior Art